Europäisches Patentamt

(19) European Patent Office

Office européen des brevets

(11) Publication number: **0 315 343**
**A1**

## (12) EUROPEAN PATENT APPLICATION

(21) Application number: 88309883.2

(51) Int. Cl.⁴: **H05K 3/34 , B23K 35/22**

(22) Date of filing: 20.10.88

(30) Priority: 21.10.87 GB 8724615
20.01.88 GB 8801185

(43) Date of publication of application:
**10.05.89 Bulletin 89/19**

(84) Designated Contracting States:
**DE FR GB IT**

(71) Applicant: **Coates Brothers PLC**
**Cray Avenue St. Mary Cray**
**Orpington Kent BR5 3PP(GB)**

(72) Inventor: **Cockett, Michael Anthony**
**Honywood House High Street**
**Lenham Maidstone ME17 2QB(GB)**
Inventor: **Thatcher, Wrenford John**
**32 Mendip Drive**
**Frome Somerset BA11 2HT(GB)**

(74) Representative: **Lamb, John Baxter et al**
**MARKS & CLERK 57/60 Lincoln's Inn Fields**
**London WC2A 3LS(GB)**

(54) Solder masks.

(57) A method of forming a solder mask upon a printed circuit board comprises the steps of:

(a) applying a layer of volatile organic liquid to the board so that the liquid layer coats non-track areas of the board but is effectively absent from the tracked areas of the board;

(b) applying a layer of liquid solder resist material to the coated board; and

(c) curing the liquid solder resist material in the desired pattern, to form the desired solder mask.

EP 0 315 343 A1

## SOLDER MASKS

This invention is concerned with improvements in and relating to the formation of solder masks on printed circuit boards and like substrates.

In order to provide for the attachment of electrical components to a printed circuit board of the type comprising a patterned layer of an electrically conductive metal (commonly copper, tin/lead or nickel) on an electrically non-conductive substrate (generally a plastics impregnated substrate), a solder mask, (i.e. a patterned layer of a solder resistant material or so-called "solder resist"), is applied to the board so as to expose parts of the patterned metal layer, and the so-coated board is then contacted with molten solder so that the solder adheres to the patterned metal layer of the exposed portions thereof. Generally, before the board is contacted with solder, the electrical components are placed on the other side of the board with the conducting elements extending therefrom passing through holes in the board into the exposed portions of the patterned metal layer.

A variety of materials can be employed for forming solder masks, including liquid compositions which may be applied to a board by, for example, roller coating, curtain coating screen printing or the like. Nowadays, most such liquid compositions are photocurable or photopolymerizable, that is they are cured or polymerized on exposure to appropriate radiation, typically UV radiation. This makes it possible to form a patterned layer of solder resist upon a board by the steps of forming a generally continuous layer of resist on the board, imagewise exposing the resist to appropriate radiation, and subsequently removing unexposed (uncured) portions of the resist, in a development step, by washing with a solvent for the uncured composition. In some cases it is necessary or desirable to later post-cure the photocured resist, typically by heating or stoving, but in the product cases such post-curing is not necessary, as for, for example, in the case of the other "Imagecure" sold by the applicants and described in GB-B-2032939.

The formation of solder masks using liquid solder resist materials is not wholly without disadvantages or problems. During the application of a liquid solder resist to a printed circuit board there is a tendency, especially with curtain coating, for the liquid resist to penetrate holes in the board. In certain circumstances such material can be difficult to remove. Residues left in the hole after photocuring render the circuit board unacceptable for use, such residues impeding soldering in of the desired electrical components. Some circuit boards, notably those with tin/lead tracks and, especially, high technology boards with the tracks very close together, require comparatively thick films of liquid solder resist in order that the tracks may be covered with an adquate layer. This thicker film not only has a greater tendency to penetrate through holes in the board but also gives rise to problems in drying. The entrapped air, both in the material and in the board surface, may become permanently dried into the film as a bubble, having risen from the board surface and expanded in the course of heating (during drying). Such bubbles are unacceptable to circuit board manufacturers so that boards so affected are rejected.

It has now been found, in accordance with the present invention, the above problems may be mitigated to a large extent by applying to the board, before application of the liquid solder resist material, a layer of a coating of a volatile organic liquid which layer covers portions of the board not coated with the patterned metal layer (the non-track areas of the board) but does not cover the patterned metal surface (the tracks) to any appreciable or effective extent. The volatile liquid penetrates or tents over the holes in the circuit board.

According to one embodiment of the invention, therefore, there is provided a method of forming a solder mask upon a printed circuit board which comprises the steps of:

(a) applying a layer of volatile organic liquid to the board so that the liquid layer coats non-track areas of the board, including any holes, but is effectively absent from the tracked areas of the board;

(b) applying a layer of liquid solder resist material to the coated board; and

(c) curing the liquid solder resist material in the desired pattern, to form the desired solder mask.

The volatile organic liquid applied to the printed circuit board, in the first step of the method of the invention, should be compatible with the liquid photoresist material, that is it should be soluble or miscible with the liquid component(s) thereof. Thus, it is convenient, in the case of a solder resist material which already contains a volatile liquid as solvent or diluent, to employ that solvent in the first stage of the method of the invention. Of course, other solvents miscible with the primary solvent of the liquid resist material can be employed. A wide variety of liquid organic materials can be used for this purpose and examples of these are include ethylene glycol monobutyl ether acetate, propylene glycol monomethyl ether, and other appropriate ethers and ether esters.

The organic liquid should not be present on the tracked portion of the board to any effective extent, that is it should not be present in an amount to adversely effect the formation of the layer of solder resist on the tracts. Whilst, ideally, there may be no liquid on the tracks, we have found that it is not necessary to scrupulously dry the track surface but that a simple mechanical treatment, equivalent to wiping with an elastomeric doctor blade, removes sufficient organic liquid from the tracks for satisfactory operation in accordance with the invention. Thus the organic liquid coating on the board is conveniently formed in a two step process in which the organic liquid is first applied over the whole of the surface of the board and into any holes by any suitable means, such as roller coating with a squeeze roller or gravure roller. Surplus or excess liquid is then removed from the track portion of the coated board by means of a doctor blade portions of the board coated therewith is suitably 2 to 10 microns, preferably 4 to 6 microns.

In step (b) of the method of the invention, the liquid solder resist material may be applied to the board, bearing the layer of low viscosity liquid, by any suitable means, as noted above.

In the third step of the method of the invention, the liquid solder resist is converted to a patterned, solder mask. This step will generally be carried out by conventional imagewise photocuring of the liquid solder resist, followed by development and any desired post-curing, as discussed above.

In order that the invention may be well understood, the following examples are given by way of illustration only.

Example 1

A squeegee roller, saturated in ethylene glycol monobutyl ether acetate was used to apply a film of about 5 to 10 gsm (grams per square meter) of the fluid over the printed circuit board. Excess fluid was immediately removed by a polyurethane doctor blade having the effect of wiping most of the fluid off the high tracks.

The board was subsequently curtain coated with a liquid photo-definable solder resist having a viscosity of 70 seconds Ford Cup 4. The coating weight was about 130 gsm.

Boards so treated exhibited an insignificant quantity of photoresist in the plated through holes (PTHs). A normal penetration would be approximately one third to one half the depth of the hole. Subsequent development in butyl carbitol gave clear holes where previously this was not possible, especially with very small via holes below 0.3 mm diameter.

Boards so treated did not exhibit the problems usually experienced of bubbles adjacent to the tracks.

Example 2

As for Example 1, but with the coating fluid in the squeegee roller replaced by Dowanol (a faster drying solvent): propylene glycol monomethyl ether. Good results were again obtained.

Example 3

As Example 1, except the boards were screen printed, using a hand held blade and a 34-36T mesh. Boards were coated with Coates screen printed Imagecure XV100 to a weight of approximately 100 gsm. The same result was obtained as in Example 1.

**Claims**

1. A method of forming a solder mask upon a printed circuit board which comprises the steps of:

(a) applying a layer of volatile organic liquid to the board so that the liquid layer coats non-track areas of the board but is effectively absent from the tracked areas of the board;

(b) applying a layer of liquid solder resist material to the coated board; and

(c) curing the liquid solder resist material in the desired pattern, to form the desired solder mask.

| | European Patent Office | EUROPEAN SEARCH REPORT | Application Number |
|---|---|---|---|

EP 88 30 9883

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 194 653 (M&T CHEMICALS INC.) * Columns 1,2 * --- | 1 | H 05 K 3/34 B 23 K 35/22 |
| A | US-A-4 615 479 (S. OHOTOSHI) * Column 1, lines 24-44; column 4, lines 14-58 * --- | 1 | |
| A | US-A-2 885 601 (L. PESSEL) * Claim 1; column 1, lines 60-71 * --- | 1 | |
| A | US-A-4 506 004 (D.F. SULLIVAN) * Column 1, line 66 - column 2, line 2, lines 24-33,64-68; column 3, lines 40-48; claim 1 * ----- | 1 | |
| | | | **TECHNICAL FIELDS SEARCHED (Int. Cl.4)** |
| | | | H 05 K B 23 K |

The present search report has been drawn up for all claims

| Place of search | Date of completion of the search | Examiner |
|---|---|---|
| THE HAGUE | 17-02-1989 | MOMENE Y ARROYO M.E. |